Europäisches Patentamt

European Patent Office

Office européen des brevets

(19)

(11) **EP 0 893 880 B1**

(12) **EUROPÄISCHE PATENTSCHRIFT**

(45) Veröffentlichungstag und Bekanntmachung des Hinweises auf die Patenterteilung:
**26.11.2003 Patentblatt 2003/48**

(51) Int Cl.⁷: **H03F 3/45**

(21) Anmeldenummer: **98112141.1**

(22) Anmeldetag: **30.06.1998**

(54) **Verstärkerstufe mit konstanter Eingangsimpendanz**

Amplifier stage with constant input impedance

Etage amplificateur à impédance d'entrée constante

(84) Benannte Vertragsstaaten:
**DE FR GB SE**

(30) Priorität: **22.07.1997 DE 19731459**

(43) Veröffentlichungstag der Anmeldung:
**27.01.1999 Patentblatt 1999/04**

(73) Patentinhaber: **Infineon Technologies AG**
**81669 München (DE)**

(72) Erfinder: **Weber, Stephan, Dr.**
**81739 München (DE)**

(74) Vertreter: **Epping Hermann & Fischer**
**Ridlerstrasse 55**
**80339 München (DE)**

(56) Entgegenhaltungen:
EP-A- 0 696 847  DE-A- 2 804 064
GB-A- 2 256 336  US-A- 4 105 942
US-A- 4 853 647  US-A- 5 382 917

**Beschreibung**

Die Erfindung betrifft eine Verstärkerstufe mit konstanter. Eingangsimpedanz. Die erfindungsgemäße Verstärkerstufe ist regelbar.

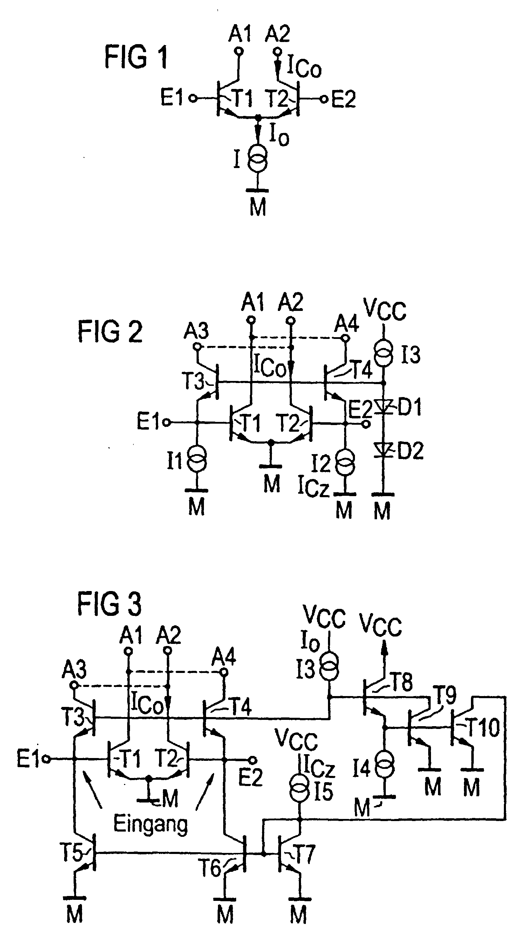

Aus dem Stand der Technik U. Tietze, CH. Schenk, Halbleiterschaltungstechnik, 10. Auflage, Springer-Verlag, 1993, Seiten 66 bis 71 ist eine emittergekoppelte Verstärkerstufe zur Differenzverstärkung bekannt. Eine entsprechende Ausführung gemäß dem Stand der Technik ist in Figur 1 gezeigt. Ein erster Transistor T1 und ein zweiter Transistor T2 sind über die Emitteranschlüsse miteinander verbunden und über eine Stromquelle I, durch die ein Strom $I_o$ fließt, an ein erstes Bezugspotential M angeschlossen. Die Eingangsspannungen UE1 und UE2 werden an die Eingangsklemmen E1 und E2, die wiederum mit den Basisanschlüssen der Transistoren T1 bzw. T2 verbunden sind, angelegt. Die Kollektoren der Transistoren T1 und T2 sind mit den Ausgangsklemmen A1 und A2 verbunden, an welchen die verstärkte Differenzspannung abgreifbar ist. Die Verstärkung wird mittels der Stromquelle I eingestellt. Nachteilig an dieser Schaltung ist vor allem, daß die Eingangsimpedanz der beiden Differenzverstärkerzweige sich stark mit dem Ruhestrom ändert.

Ein Differenzverstärker ist ein symmetrischer Gleichspannungsverstärker mit zwei Eingängen und zwei Ausgängen. Kennzeichnend ist die Stromquelle in der gemeinsamen Emitterleitung. Sie bewirkt, daß die Summe der Emitterströme IE1 + IE2 = I0 konstant bleibt. Im Ruhezustand ist die Eingangsspannung an der Klemme E1 gleich der Eingangsspannung an der Klemme E2, die wiederum 0 sind. In diesem Fall teilt sich der Konstantstrom I0 aus Symmetriegründen gleichmäßig auf die beiden Transistoren T1 und T2 auf. Die Differenzverstärkung AD ergibt sich zu AD = dUA1 : dUD, wobei sich die Differenzspannung UD aus UD = UE1 - UE2 ergibt.

Verändert man jedoch die Eingangsspannungen zu beispielsweise UE1 größer UE2, dann ändert sich die Stromaufteilung in Differenzverstärker, so daß IC1 (Kollektorstrom im Transistor T1) zunimmt und IC2 (Kollektorstrom im Transistor 2) abnimmt. Die Summe der Ströme IC1 + IC2 bleibt jedoch konstant. Eine Eingangsspannungsdifferenz ruft demnach eine Ausgangsspannungsänderung hervor. Differenzverstärker werden auch dann eingesetzt, wenn keine Spannungsdifferenz sondern nur eine der beiden Eingangsspannungen UE1 oder UE2 verstärkt werden soll. In diesem Fall legt man einen der beiden Eingänge E1 oder E2 auf Nullpotential.

Eine besondere Differenzverstärkerstufe ist aus DE 28 04 064 bekannt geworden. Dabei ist eine emittergekoppelte Differenzverstärkerstufe mit einer basisgekoppelten Differenzverstärkerstufe verbunden, wobei die Kollektoren beider Stufen kreuzgekoppelt sind und die Ausgänge der Verstärkerschaltung bilden.

Eine Aufgabe der Erfindung ist es, eine Verstärkerstufe mit konstanter Eingangsimpedanz anzugeben, die einen möglichst großen Dynamikbereich bei sonst weitgehend konstanten Verstärkerparametern, wie Verzerrung, Rauschen usw. aufweist.

Die Aufgabe wird durch eine Verstärkerstufe gemäß Patentanspruch 1 gelöst.

Vorteilhafte Weiterbildungen ergeben sich aus den abhängigen Ansprüchen.

So ist es von Vorteil, die impedanzbehafteten Zweige, die zu den beiden Differenzverstärkerzweigen parallel geschaltet sind, so auszulegen, daß mit einer Zunahme der Eingangsimpedanz der Differenzverstärkerzweige die Impedanzen der impedanzbehafteten Zweige entsprechend abnehmen.

Gemäß der Erfindung ist vorgesehen, daß der erste Differenzverstärkerzweig einen ersten und der zweite Differenzverstärkerzweig einen zweiten Transistor aufweist, wobei die beiden Transistoren emittergekoppelt und deren Basisanschlüsse mit den Eingängen der Verstärkerstufe verbunden sind. Weiterhin sind eine erste und eine zweite Stromquelle vorgesehen, die einerseits mit den Basisanschlüssen des ersten und des zweiten Transistors und andererseits mit einem ersten Bezugspotential verbunden sind. Die Basisanschlüsse eines dritten und eines vierten Transistors sind bei der vorliegenden Ausführungsform miteinander verbunden und emitterseitig mit den Basisanschlüssen des ersten und zweiten Transistors verbunden. Mit einem Mittel zur Arbeitspunkteinstellung der Verstärkerstufe, das einerseits mit den Basisanschlüssen des dritten und des vierten Transistors und andererseits mit dem ersten Bezugspotential verbunden ist, wird der Arbeitspunkt der erfindungsgemäßen Verstärkerstufe eingestellt. Eine dritte Stromquelle ist einerseits mit den Basisanschlüssen des dritten und des vierten Transistors und andererseits mit einem zweiten Bezugspotential verbunden. Die Kollektoren der ersten vier Transistoren bilden die Ausgänge der Verstärkerstufe.

Als Mittel zum Einstellen des Arbeitspunkts der Verstärkerstufe können beispielsweise eine oder mehrere Dioden vorgesehen sein.

Gemäß der Erfindung ist neben den ersten vier Transistoren, die, wie in der obengenannten Ausführungsform beschrieben, verbunden sind, ein Stromspiegel vorgesehen, der eingangsseitig mit einem weiteren Transistor, im folgenden als zehnter Transistor bezeichnet, und ausgangsseitig mit dem Basisanschlüssen des ersten und zweiten Transistors verbunden ist. Wie in der obigen Ausführungsform ist die dritte Stromquelle einerseits mit den Basisanschlüssen des dritten und vierten Transistors und andererseits mit einem zweiten Bezugspotential verbunden. Das Mittel zum Einstellen des Arbeitspunkts der Verstärkerstufe ist einerseits mit den Basisanschlüssen des dritten und vierten Transistors und andererseits mit dem ersten Bezugspotential verbunden. Die Kollektoren der ersten vier Transistoren bilden wiederum die Ausgänge der Verstärkerstufe.

Weiterhin können ein fünfter und ein sechster Transistor vorgesehen sein, deren Kollektor-Emitter-Strecken einerseits mit den Basisanschlüssen des ersten und zweiten Transistors und andererseits mit dem ersten Bezugspotential verbunden sind. Neben dem fünften und sechsten Transistor weist der Stromspiegel auch einen siebten Transistor auf, wobei dieser als Diode arbeitet, die einerseits mit dem ersten Bezugspotential und andererseits mit dem Kollektoranschluß des zehnten Transistors verbunden ist. Damit der siebte Transistor als Diode arbeitet, ist dessen Kollektoranschluß mit dem Basisanschluß kurzgeschlossen.

Das Mittel zum Einstellen des Arbeitspunktes weist einen achten und einen neunten Transistor auf, wobei der Basisanschluß des achten Transistors mit den Basisanschlüssen des dritten und vierten Transistors und dem Kollektoranschluß des neunten Transistors verbunden ist. Der Kollektoranschluß des achten Transistors ist mit dem zweiten Bezugspotential und der Emitteranschluß mit einer vierten Stromquelle und dem Basisanschluß des neunten und zehnten Transistors verbunden.

Indem zwischen den Stromspiegel und das erste Bezugspotential Widerstände geschaltet sind, d. h. die Emitter des fünften, sechsten und siebten Transistors sind über jeweils einen Widerstand mit dem ersten Bezugspotential verbunden, wird eine Verringerung der Exemplarstreuung und eine Verbesserung der Linearität erreicht.

Zwischen den Basisanschlüssen des dritten und vierten Transistors und dem ersten Bezugspotential kann ein Kondensator vorgesehen sein. Dieser dient zur Frequenzkompensation und damit zur Stabilisierung der Frequenzverstärkerstufe.

Zwischen den Emitteranschluß des achten Transistors und dem ersten Bezugspotential kann ein Widerstand vorgesehen sein. Dieser ersetzt die vierte Stromquelle. Weiterhin kann zwischen dem Emitteranschluß des zehnten Transistors und dem ersten Bezugspotential ein Widerstand vorgesehen sein. Die Widerstände zwischen dem Stromspiegel und dem ersten Bezugspotential und der Widerstand zwischen dem Emitteranschluß des zehnten Transistors und dem ersten Bezugspotential dienen zur Stromgegenkopplung und damit zur Reduzierung von Rauschen.

Die erfindungsgemäße Verstärkerstufe kann sowohl mit pnp- als auch npn-Transistoren ausgeführt sein. Es ist auch möglich, anstelle von Bipolartransistoren Feldeffekttransistoren einzusetzen.

Die erfindungsgemäße Schaltung weist zwei Differenzverstärkerzweige auf, deren Eingangsimpedanzen gegensinnig eingestellt werden, so daß die Gesamteingangsimpedanz konstant bleibt.

Die Erfindung wird anhand von vier Figuren weiter erläutert.

Figur 1    zeigt einen Differenzverstärker gemäß dem Stand der Technik.

Figur 2    zeigt den prinzipiellen Aufbau der erfindungsgemäßen Verstärkerstufe.

Figur 3    zeigt eine Ausführungsform der erfindungsgemäßen Verstärkerstufe.

Figur 4    zeigt eine weitere Ausführungsform der erfindungsgemäßen Verstärkerstufe.

Die in Figur 2 gezeigte Schaltungsanordnung weist wie der in Figur 1 gezeigte Stand der Technik einen ersten, den ersten Transistor T1 und einen zweiten, den zweiten Transistor T2 aufweisenden Differenzverstärkerzweig auf. Anders als im Stand der Technik gemäß Figur 1 ist in Figur 2 der Zusammenschluß der beiden Emitteranschlüsse des ersten und des zweiten Transistors T1 und T2 auf das erste Bezugspotential M gelegt. Der Basisanschluß des ersten Transistors T1 führt auf die Eingangsklemme E der Verstärkerstufe, eine erste Stromquelle I1 und den Emitteranschluß eines dritten Transistors T3. Der zweite Anschluß der ersten Stromquelle I1 liegt auf dem ersten Bezugspotential M. Der Basisanschluß des zweiten Transistors T2 führt auf die zweite Eingangsklemme E2 der Verstärkerstufe, den Emitteranschluß eines vierten Transistors T4 und eine zweite Stromquelle I2. Der zweite Anschluß der zweiten Stromquelle I2 liegt auf dem ersten Bezugspotential M. Die Basisanschlüsse des dritten und des vierten Transistors T3 und T4 sind sowohl miteinander als auch mit dem Anodenanschluß einer ersten Diode D1 und einer dritten Stromquelle I3 verbunden. Der zweite Anschluß der dritten Stromquelle I3 liegt auf einem zweiten Bezugspotential VCC. In Reihe zur ersten Diode D1 ist eine zweite Diode D2 geschaltet, deren Kathodenanschluß mit dem ersten Bezugspotential M verbunden ist. Die Kollektoranschlüsse des ersten, zweiten, dritten und vierten Transistors T1, T2, T3 und T4 führen auf die Ausgangsklemmen A1, A2, A3 bzw. A4 der Verstärkerstufe. Durch die zweite Stromquelle I2 fließt der Strom ICZ. Der Kollektorstrom des zweiten Transistors T2 wird mit ICO bezeichnet. Ein Ansteigen der Eingangsimpedanz der durch den ersten und zweiten Transistor T1 und T2 gebildeten Emitterschaltung wird durch die Schaltung gemäß Figur 2 dadurch kompensiert, daß der Eingangsimpedanz der Emitterschaltung ein erster und ein zweiter impedanzbehafteter Zweig parallel geschaltet ist. Steigt der Eingangsimpedanz ZINCE (CE = Common Emitter) so wird auch der Leitwert des impedanzbehafteten Zweigs vergrößert. Die Eingangsimpdanz ZINCE bestimmt sich zu

$$ZINCE = \beta \cdot UT : IC0,$$

wobei
$\beta$ = Kleinsignal-Stromverstärkung
UT = Temperaturspannung
ICO = Kollektorstrom

In der Ausführung gemäß Figur 2 wird zur Festlegung des Arbeitspunkts der Verstärkerschaltung die niederohmige Eingangsimpedanz der Basisschaltung, gebildet durch den dritten und den vierten Transistor T3, T4 und einer Basis-Emitter-Diode verwendet. Die Eingangsimpedanz ZINCB (CB = Common Basis) bestimmt sich zu

$$ZINCB = UT : ICZ$$

wobei ICZ = Strom, der durch die zweite Stromquelle I2 fließt.

Die gesamte Eingangsadmittanz YGES = 1/ZGES für den ersten bzw. den zweiten Verstärkerzweig ergibt sich dann zu:

$$YGES = ICO : \beta UT + ICZ : UT + YP$$

wobei YP = parasitärer Anteil, der meist wenig stromabhängig ist.

Die Ausgänge A3 und A4 der Verstärkerstufe können, falls gewünscht, auf das zweite Bezugspotential VCC gelegt werden.

Um die Eingangsimpedanz ZIN der Verstärkerstufe konstant zu halten, sind die Ruheströme wie folgt einzustellen:

$$ICO : \beta UT + ICZ : UT = k$$

Daraus folgt

$$ICZ = UT \cdot (k - ICO : \beta UT) = k' - ICO : \beta$$

wobei k' = UT · k. Der Zusatzstrom ICZ hat also einen Konstantanteil k', der in dem Maß reduziert wird, indem der Strom ICO ansteigt.

Die dritte Stromquelle I3 dient zur Einprägung der Konstantstromverstärkung, welche von der Eingangsimpedanz ZIN abhängt. Hingegen dient die zweite Stromquelle I2 der Einprägung der Konstantstromverstärkung unabhängig von der Eingangsimpedanz ZIN.

Die in Figur 3 gezeigte Ausführungsform weist ebenfalls einen ersten und einen zweiten Differenzverstärkerzweig auf. Der Emitteranschluß des ersten Transistors T1 ist entsprechend der Darstellung in Figur 2 mit dem Emitteranschluß des zweiten Transistors T2 verbunden und liegt auf dem ersten Bezugspotential M. Der Basisanschluß des ersten Transistors ist jetzt mit dem Kollektor eines fünften Transistors T5, der Eingangsklemme E1 der Verstärkerstufe und dem Emitter des dritten Transistors T3 verbunden. Symmetrisch dazu ist der Basisanschluß des zweiten Transistors T2 mit dem Kollektor eines sechsten Transistors T6, der zweiten Eingangsklemme E2 der Verstärkerstufe und dem Emitter des vierten Transistors T4 verbunden. Die Basisanschlüsse der in Basisschaltung angeordneten Transistoren T3 und T4 sind mit der dritten Stromquelle I3 und der Basis eines achten Transistors T8 verbunden. Die zweite Klemme der dritten Stromquelle I3 liegt auf dem zweiten Bezugspotential VCC ebenso wie der Kollektoranschluß des achten Transistors T8. Der Basisanschluß des achten Transistors T8 führt auf eine vierte Stromquelle I4 und die Basisanschlüsse eines neunten Transistors T9 und eines zehnten Transistors T10. Deren Emitteranschlüsse sind ebenso wie der zweite Anschluß der vierten Stromquelle I4 auf das erste Bezugspotential M gelegt. Der Ausgangskreis des zehnten Transistors T10 führt auf eine fünfte Stromquelle I5, den Kollektoranschluß eines siebten Transistors T7 und die Basisanschlüsse der Transistoren T5, T6 und T7.

Der fünfte, sechste und siebte Transistor T5, T6 und T7 bilden einen Stromspiegel, der eingangsseitig mit der fünften Stromquelle I5 und dem zehnten Transistor T10 und ausgangsseitig mit den Transistoren T1 und T2 verbunden ist. Der Transistor T7 ist dabei als Diode geschaltet.

Mit der vierten Stromquelle I4 wird ein Hilfsstrom eingeprägt, der dafür sorgt, daß durch den achten Transistor T8 ein Strom fließt. Die Kollektoranschlüsse der ersten vier Transistoren T1, T2, T3 und T4 bilden, wie gehabt, die Ausgänge A1, A2, A3 bzw. A4 der Verstärkerstufe. Durch den Kollektor des zweiten Transistors T2 fließt der Strom ICO. Die dritte Stromquelle I3 prägt einen Strom I0 und die fünfte Stromquelle einen Strom ICZ ein. Mit Hilfe der Transistoren T8 und T9 wird der Arbeitspunkt der Verstärkerschaltung eingestellt.

Zusätzlich besteht die Möglichkeit Emitterwiderstände zur Verringerung der Exemplarstreuungen und zur Verbesserung der Linearität und Basiswiderstände zur Schwingungsbedämpfung und zur Kompensation der Kleinsignalverstärkung einzusetzen.

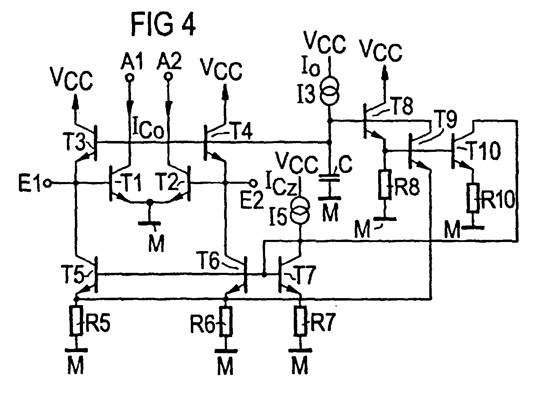

Um die Verstärkerstufe zu regeln, hält man den Strom ICZ konstant und variiert I0 der durch die dritte Stromquelle I3 eingeprägt wird. Falls die Eingangsimpedanz ZIN in geringem Maße variieren darf, kann der Arbeitspunkt über Stromquellen gemäß der in Figur 4 gezeigten Ausführungsform eingestellt werden. Die Schaltungsanordnung bezüglich der Transistoren T1, T2, T3, T4, T5, T6, T7, T8, T9, T10 und der Stromquellen I3 und I5 entspricht dabei der in Figur 3 gezeigten Schaltungsanordnung. Zusätzlich sind zwischen die Emitteranschlüsse der Transistoren T5, T6, T7, T10 und dem ersten Bezugspotential M Widerstände R5, R6, R7 bzw. R10 eingefügt. Die vierte Stromquelle I4 aus Figur 3 ist durch einen Widerstand R8 ersetzt worden. Weiterhin wurde ein Kondensator C zwischen die Basisanschlüsse der Transistoren T3 und T4 und dem ersten Bezugspotential M eingefügt.

Die Widerstände R5, R6, R7 und R10 dienen der Stromgegenkopplung und damit der Rauschreduzierung. Der Kondensator C dient der Frequenzkompensation und damit zur Stabilisierung der Verstärkerstufe. Die Kollektoren der Basisschaltung (Transistoren T3 und T4) sind auf das zweite Bezugspotential VCC gelegt, so daß die Verstärkung bei einem kleinen Strom I0 sinkt und der Regelbereich vergrößert wird. Außerdem steuert der Stromspiegel (Transistoren T5, T6, T7) den Strom I0 und gleichzeitig ICZ. Dies bewirkt eine eher gleitende Änderung der Eingangsimpedanz ZIN.

Grundsätzlich können die in den Figuren gezeigten npn-Transistoren durch pnp-Transistoren oder auch Feldeffekttransistoren ersetzt werden. Auch kann die Gegentaktemitterschaltung durch einen normalen Differenzverstärker mit Stromquelle ersetzt werden.

Die in Figur 4 gezeigten Emitterwiderstände dienen zur Verringerung der Exemplarstreuung und zur Verbesserung der Linearität.

**Patentansprüche**

1.  Verstärkerstufe mit konstanter Eingangsimpedanz,

    - bei der ein erster Differenzverstärkerzweig einen ersten und ein zweiter Differenzverstärkerzweig einen zweiten Transistor (T1, T2) aufweist, wobei die Transistoren emittergekoppelt und deren Basisanschlüsse mit den Eingängen (E1, E2) der Verstärkerstufe verbunden sind,
    - bei der eine erste und eine zweite Stromquelle (I1, I2) vorgesehen sind, die einerseits mit den Basisanschlüssen des ersten und des zweiten Transistors (T1, T2) und andererseits mit einem ersten Bezugspotential (M) verbunden sind,
    - bei der ein dritter und ein vierter Transistor (T3, T4) vorgesehen sind, deren Basisanschlüsse miteinander verbunden sind und die emitterseitig mit den Basisanschlüssen des ersten und des zweiten Transistors (T1, T2) verbunden sind,

    **dadurch gekennzeichnet daß**,

    - ein Mittel zum Einstellen des Arbeitspunkts der Verstärkerstufe (T8, T9) vorgesehen ist, das einerseits mit den Basisanschlüssen des dritten und vierten Transistors (T3, T4) und andererseits mit dem ersten Bezugspotential (M) verbunden ist,
    - eine dritte Stromquelle (I3) vorgesehen ist, die einerseits mit den Basisanschlüssen des dritten und vierten Transistors (T3, T4) und andererseits mit einem zweiten Bezugspotential (Vcc) verbunden ist,
    - die Kollektoren der vier Transistoren (T1, T2, T3, T4) die Ausgänge der Verstärkerstufe (A1, A2, A3, A4) bilden, und
    - die erste und zweite Stromquelle (I1, I2) durch einen Stromspiegel (T5, T6, T7) gebildet sind, der eingangsseitig mit einem weiteren Transistor (T10) und ausgangsseitig mit den Basisanschlüssen des ersten und des zweiten Transistors (T1, T2) verbunden ist, wobei der weitere Transistor (T10) einen Steuereingang aufweist, der mit dem Mittel zum Einstellen des Arbeitspunktes der Verstärkerstufe (T8, T9) verbunden ist, und eine gesteuerte Strecke umfaßt mit einem Anschluß, der mit dem Stromspiegel verbunden ist.

2.  Verstärkerstufe nach Anspruch 1,
    **dadurch gekennzeichnet daß**,

    - der Stromspiegel einen fünften und einen sechsten Transistor (T5, T6) aufweist, deren Kollektor-Emitterstrecken einerseits mit den Basisanschlüssen des ersten und des zweiten Transistors (T1, T2) und andererseits mit einem ersten Bezugspotential (M) verbunden sind, und
    - der Stromspiegel einen siebten Transistor (T7) aufweist, der als Diode arbeitet, die einerseits mit dem ersten Bezugspotential (M) und andererseits mit dem Kollektoranschluß des weiteren Transistors (T10) verbunden ist, und
    - die Basisanschlüsse des fünften, sechsten und siebten Transistors (T5, T6, T7) miteinander verbunden sind.

3.  Verstärkerstufe nach Anspruch 1 oder 2,
    **dadurch gekennzeichnet daß**,

    - das Mittel zum Einstellen des Arbeitspunkts (T8, T9) einen achten und einen neunten Transistor (T8, T9) aufweist,
    - der Basisanschluß des achten Transistors (T8) mit den Basisanschlüssen des dritten und des vierten Transistors (T3, T4) und dem Kollektoranschluß des neunten Transistors (T9) verbunden ist, und
    - der Kollektoranschluß des achten Transistors (T8) mit dem zweiten Bezugspotential (Vcc) und der Emitteranschluß mit einer vierten Stromquelle (I4) und dem Basisanschluß des neunten und des weiteren Transistors (T9, T10) verbunden ist.

4.  Verstärkerstufe nach Anspruch 3,
    **dadurch gekennzeichnet daß**,

    - zwischen den Stromspiegel (T5, T6, T7) und das erste Bezugspotential (M) Widerstände (R5, R6, R7) geschaltet sind.

5.  Verstärkerstufe nach einem der Ansprüche 1-4,

    - bei der das Mittel zum Einstellen des Arbeitspunkts mindestens eine Diode aufweist.

**6.** Verstärkerstufe nach einem der vorhergehenden Ansprüche,
**dadurch gekennzeichnet daß**,

- zwischen den Basisanschlüssen des dritten und des vierten Transistors (T3, T4) und dem ersten Bezugspotential (M) ein Kondensator (C) vorgesehen ist.

**7.** Verstärkerstufe nach einem der vorhergehenden Ansprüche,
**dadurch gekennzeichnet daß**,

- zwischen dem Emitterschluß des achten Transistors (T8) und dem ersten Bezugspotential (M) ein Widerstand (R8) vorgesehen ist.

**8.** Verstärkerstufe nach einem der vorhergehenden Ansprüche,
**dadurch gekennzeichnet daß**,

- zwischen dem Emitterschluß des weiteren Transistors (T10) und dem ersten Bezugspotential (M) ein Widerstand (R10) vorgesehen ist.

**Claims**

**1.** Amplifier stage having a constant input impedance,

- in which a first differential amplifier path has a first transistor (T1) and a second differential amplifier path has a second transistor (T2), the transistors being emitter-coupled and the base connections of said transistors being connected to the inputs (E1, E2) of the amplifier stage,
- in which a first and a second current source (I1, I2) are provided which are connected firstly to the base connections of the first and second transistors (T1, T2) and secondly to a first reference-potential (M),
- in which a third and a fourth transistor (T3, T4) are provided, the base connections of said transistors being connected to one another and the emitter side of said transistors being connected to the base connections of the first and second transistors (T1, T2),

**characterized in that**

- a means for setting the operating point of the amplifier stage (T8, T9) is provided which is connected firstly to the base connections of the third and fourth transistors (T3, T4) and secondly to the first reference-potential (M),
- a third current source (I3) is provided which is connected firstly to the base connections of the third and fourth transistors (T3, T4) and secondly to a second reference potential (Vcc),
- the collectors of the four transistors (T1, T2, T3, T4) form the outputs of the amplifier stage (A1, A2, A3, A4), and
- the first and second current sources (I1, I2) are formed by a current mirror (T5, T6, T7) whose input side is connected to a further transistor (T10) and whose output side is connected to the base connections of the first and second transistors (T1, T2), the further transistor (T10) having a control input which is connected to the means for setting the operating point of the amplifier stage (T8, T9) and comprising a controlled section which has a connection which is connected to the current mirror.

**2.** Amplifier stage according to Claim 1,
**characterized in that**

- the current mirror has a fifth and a sixth transistor (T5, T6) whose collector-emitter paths are connected firstly to the base connections of the first and second transistors (T1, T2) and secondly to a first reference-potential (M), and
- the current mirror has a seventh transistor (T7) which operates as a diode which is connected firstly to the first reference-potential (M) and secondly to the collector connection of the further transistor (T10), and
- the base connections of the fifth, sixth and seventh transistors (T5, T6, T7) are connected to one another.

**3.** Amplifier stage according to Claim 1 or 2,
**characterized in that**

- the means for setting the operating point (T8, T9) have an eighth and a ninth transistor (T8, T9),
- the base connection of the eighth transistor (T8) is connected to the base connections of the third and fourth transistors (T3, T4) and to the collector connection of the ninth transistor (T9), and
- the collector connection of the eighth transistor (T8) is connected to the second reference potential (Vcc), and the emitter connection is connected to a fourth current source (I4) and to the base connection of the ninth and of the further transistor (T9, T10).

**4.** Amplifier stage according to Claim 3,
**characterized in that**

- the current mirror (T5, T6, T7) and the first reference-potential (M) have resistors (R5, R6, R7) connected between them.

**5.** Amplifier stage according to one of Claims 1-4,

- in which the means for setting the operating point has at least one diode.

**6.** Amplifier stage according to one of the preceding claims,
**characterized in that**

- the base connections of the third and fourth transistors (T3, T4) and the first reference-potential (M) and a capacitor (C) is provided between them.

**7.** Amplifier stage according to one of the preceding claims,
**characterized in that**

- the emitter short [sic] of the eighth transistor (T8) and the first reference-potential (M) have a resistor (R8) provided between them.

**8.** Amplifier stage according to one of the preceding claims,
**characterized in that**

- the emitter short [sic] of the further transistor (T10) and the first reference-potential (M) have a resistor (R10) provided between them.

**Revendications**

**1.** Étage amplificateur à impédance d'entrée constante,

- dans lequel une première branche d'amplificateur différentiel a un premier transistor (T1) et une deuxième branche d'amplificateur différentiel a un deuxième transistor (T2), les transistors étant à couplage d'émetteur et leurs bornes de base étant reliées aux entrées (E1 ; E2) de l'étage amplificateur ;
- dans lequel il est prévu une première et une deuxième source (I1, I2) de courant, qui sont reliées d'une part aux bornes de base du premier et du deuxième transistor (T1, T2) et d'autre part à un premier potentiel (M) de référence ;
- dans lequel il est prévu un troisième et un quatrième transistor (T3, T4) dont les bornes de base sont reliées entre elles et qui sont reliées du côté émetteur aux bornes de base du premier et du deuxième transistor (T1, T2),

    **caractérisé en ce que**

- il est prévu un moyen de réglage du point de travail de l'étage (T8, T9) amplificateur, qui est relié d'une part aux bornes de base des troisième et quatrième transistors (T3, T4) et d'autre part au premier potentiel (M) de référence ;
- il est prévu une troisième source (13) de courant, qui est reliée d'une part aux bornes de base du troisième et du quatrième transistor (T3, T4) et d'autre part à un deuxième potentiel (Vcc) de référence ;
- les collecteurs des quatre transistors (T1, T2, T3, T4) forment les sorties de l'étage (A1, A2, A3, A4) amplificateur; et
- les première et deuxième sources (I1, I2) de courant sont formées par un miroir de courant (T5, T6, T7) qui, du côté de l'entrée, est relié à un autre transistor (T10) et, du côté de la sortie, aux bornes de base du premier et du deuxième transistor (T1, T2), l'autre transistor (T10) ayant une entrée de commande qui est reliée au moyen de réglage du point de travail de l'étage (T8, T9) amplificateur, et comprend une section commandée ayant une borne qui est reliée au miroir de courant.

**2.** Étage amplificateur suivant la revendication 1 ;
    **caractérisé en ce que**

- le miroir de courant a un cinquième et un sixième transistor (T5, T6) dont les sections de collecteur-émetteur sont reliées d'une part aux bornes de base du premier et du deuxième transistor (T1, T2) et d'autre part à un premier potentiel (M) de référence ; et
- le miroir de courant a un septième transistor (T7) qui fonctionne en diode; qui est relié d'une part au premier potentiel (M) de référence et d'autre part à la borne de collecteur de l'autre transistor (T10) ; et
- les bornes de base des cinquième, sixième et septième transistors (T5, T6, T7) sont reliées entre elles.

**3.** Étage amplificateur suivant la revendication 1 ou 2 ,
**caractérisé en ce que**

- le moyen de réglage du point (T8, T9) de travail comporte un huitième et un neuvième transistor (T8, T9) ;
- la borne de base du huitième transistor (T8) est reliée aux bornes de base du troisième et du quatrième transistor (T3, T4) et à la borne de collecteur du neuvième transistor (T9) ; et
- la borne de collecteur du huitième transistor (T8) est reliée au deuxième potentiel (Vcc) de référence et la borne d'émetteur à une quatrième source (14) de courant et à la borne de base du neuvième transistor (T9) à celle de l'autre transistor (T10).

4. Étage amplificateur suivant la revendication 3, **caractérisé en ce que**

   - il est monté des résistances (R5, R6, R7) entre le miroir de courant (T5, T6, T7) et le premier potentiel (M) de référence.

5. Étage amplificateur suivant l'une des revendications 1 à 4,

   - dans lequel le moyen de réglage du point de travail comporte au moins une diode.

6. Étage amplificateur suivant l'une des revendications précédentes, **caractérisé en ce que**

   - il est prévu un condensateur (C) entre les bornes de base du troisième et du quatrième transistor (T3, T4) et le premier potentiel (M) de référence.

7. Étage amplificateur suivant l'une des revendications précédentes, **caractérisé en ce que**

   - il est prévu une résistance (R8) entre la borne d'émetteur du huitième transistor (T8) et le premier potentiel (M) de référence.

8. Étage amplificateur suivant l'une des revendications précédentes, **caractérisé en ce que**

   - il est prévu une résistance (R10) entre la borne d'émetteur de l'autre transistor (T10) et le premier potentiel (M) de référence.

FIG 1

FIG 2

FIG 3

FIG 4